# EUROPEAN PATENT APPLICATION

(11) **EP 2 341 561 A2**
(43) Date of publication of application: **06.07.2011**
(21) Application number: 10167271.5
(22) Date of filing: 25.06.2010
(51) Int. Cl.: H01L 33/48, H01L 23/32

(54) **Bracket for supporting an LED**

(30) Priority: 04.12.2009 CN 200910188612
(71) Applicant: Civilight Qidong Lighting Technology Co., Ltd., Binhai Industrial Park Qidong Jiangsu (CN)
(72) Inventor: Xue, Xinshen, Shenzhen (CN); Li, Meihua, Shenzhen (CN)
(74) Representative: Erny, Tobias

(57) **Abstract**

A bracket for supporting an LED includes a top surface 1, a bottom surface 2 opposite to the top surface 1, a front surface 3, a rear surface 4 opposite to the front surface 3, a left side 5, and a right side 6 opposite to the left side 5. The front and rear surfaces 3 and 4 are a parallelogram in shape, and vertical to the bottom surface, an electrode 7 and a dissipating heat fin 8 are attached to the left and right sides 5 and 6 of the bracket, and an included angle between the left side 5 or right side 6 and the bottom surface 2 is in a range from 30 degrees to 60 degrees. The electrode 7 and dissipating heat fin 8 are attached to the bottom surface 2.

## Description

### TECHNICAL FIELD

The present invention relates to LED lighting devices, and more particularly, to a bracket for supporting LEDs.

### BACKGROUND

Currently, a conventional LED is affixed to a substrate, and a front surface of the LED emits light. Thus, the conventional LED with a small light-emitting angle, can not produce a three-dimensional light source which has better light-emitting performance in all directions. However, such product has a round lamp cup, therefore, its luminous efficiency is low, its airtightness is poor, and its dissipating heat effect is not good. Therefore, such product is not suitable for illumination.

There is, therefore, a need for a bracket for supporting LED, which causes that a light source has a large light-emitting angle, luminous efficiency of the light source is high, airtightness of the light source is improved, and dissipating heat effect the light source is good.

### SUMMARY

The conventional brackets can cause that the light source has a small light-emitting angle, luminous efficiency of the light source is low, airtightness of the light source is poor, and dissipating heat effect of the light source is poor. In order to solve the above-mentioned technical problems, the present invention provides a bracket for supporting LED used in a three-dimensional light source. To achieve these objectives, the technical scheme of the present invention includes as follows:

A bracket for supporting an LED includes a top surface, a bottom surface opposite to the top surface, a front surface; a rear surface opposite to the front surface, a left side, and a right side opposite to the left side. Wherein the front and rear surfaces are a parallelogram in shape, and vertical to the bottom surface, and wherein an electrode and a dissipating heat fin are attached to the left and right sides of the bracket, an included angle between the left side or right side and the bottom surface is in a range from 30 degrees to 60 degrees, and the electrode and dissipating heat fin are attached to the bottom surface.

Preferably, the included angle between the left side or right side and the bottom surface is 30 degrees, 45 degrees, or 60 degrees.

Preferably, the electrode and/or the dissipating heat fin are firmly attached to the left and right sides.

Preferably, the bracket further includes a rectangular cup disposed on the bottom surface.

Preferably, at least one angle is formed on a side wall of the rectangular cup, and the angle is preferably in a range from 40 degrees to 90 degrees.

Preferably, the electrode is made of copper, silver, or alloy material. Preferably, the dissipating heat fin is made of copper, silver or alloy material.

Preferably, the rectangular cup is made of conducting heat insulation material.

Preferably, the conducting heat insulation material includes ALN, ceramic, silicon substrate or plastic material.

Preferably, the rectangular cup is square or oval-shaped, and/or a corner of the rectangular cup is a rounded corner.

Preferably, the electrode and/or the dissipating heat fin extend to an external surface of the bracket, and the left side, right side or the bottom surface is preferably attached to a substrate.

Other objects, advantages and novel features of the present invention will become more apparent from the following detailed description when taken in conjunction with the accompanying drawings, in which:

### BRIEF DESCRIPTION OF THE DRAWINGS

FIG 1 is a perspective view of a bracket for supporting an LED in the present invention;

FIG 2 is a sectional view of a bracket for supporting an LED in the accordance with a first embodiment in the present invention, wherein an included angle between a left or right side of the bracket and a bottom surface of the bracket is 30 degrees, and the bottom surface of the bracket is attached to a substrate;

FIG. 3 is a sectional view of a bracket for supporting an LED in the accordance with a second embodiment in the present invention, and is similar to FIG. 2, but an included angle between a left or right side of the bracket and a bottom surface of the bracket is 45 degrees, and wherein a bottom surface of the bracket is attached to a substrate;

FIG. 4 is a sectional view of a bracket for supporting an LED in the accordance with a third embodiment in the present invention, and is similar to FIG. 2, but an included angle between a left or right side of the bracket and a bottom surface of the bracket is 60 degrees, and wherein the bottom surface of the bracket is attached to a substrate;

FIG. 5 is a sectional view of the bracket in the accordance with the first embodiment in the present invention, wherein an electrode and a dissipating heat fin are attached to the left side of the bracket and the right side of the bracket;

FIG. 6 is a sectional view of the bracket, wherein the left side of the bracket is attached to the substrate, the electrode and the dissipating heat fin are attached to the left and right sides of the bracket, and a top surface of the bracket orientates a left side;

FIG. 7 is a sectional view of the bracket in the present invention, wherein the left side of the bracket is attached to the substrate, the electrode and the dissipating heat fin are attached to the left and right sides of the bracket, and a top surface of the bracket orientates a right side;

FIG. 8 is a sectional view of the bracket in the present invention, wherein the right side of the bracket is attached to the substrate, the electrode and the dissipating heat fin are attached to the left and right sides of the bracket, and a top surface of the bracket orientates a right side;

FIG. 9 is a sectional view of the bracket in the present invention, wherein the right side of the bracket is attached to the substrate, the electrode and the dissipating heat fin are attached to the left and right sides of the bracket, and a top surface of the bracket orientates a right side;

FIG. 10 is a sectional view of the bracket in the accordance with the first embodiment in the present invention, wherein the right side of the bracket is attached to the substrate, the electrode and the dissipating heat fin are attached to the left and right sides of the bracket, a top surface of the bracket orientates a left side, and an included angle between the left side and the bottom surface of the bracket is 30 degrees;

FIG. 11 is a sectional view of the bracket in the accordance with the second embodiment in the present invention, wherein the right side of the bracket is attached to the substrate, the electrode and the dissipating heat fin are attached to the left and right sides of the bracket, a top surface of the bracket orientates a left side, and an included angle between the left side and the bottom surface of the bracket is 45 degrees; and

FIG. 12 is a sectional view of the bracket in the accordance with the third embodiment in the present invention, wherein the right side of the bracket is attached to the substrate, the electrode and the dissipating heat fin are attached to the left and right sides of the bracket, a top surface of the bracket orientates a left side, and an included angle between the left side and the bottom surface of the bracket is 60 degrees;

FIG. 13 is a front view of the bracket, wherein the bottom surface of the bracket is attached to the substrate, and an included angle between the left side and the bottom surface of the bracket is 30 degrees;

FIG. 14 is a bottom view of the bracket, wherein the bottom surface of the bracket is attached to the substrate, the electrode and the dissipating heat fin are attached to the left side, right side and bottom surface of the bracket, and an included angle between the left side and bottom surface of the bracket is 30 degrees;

FIG. 15 is a bottom view of the bracket, wherein the bottom surface of the bracket is attached to the substrate, the electrode and the dissipating heat fin are attached to the left and right sides of the bracket, and an included angle between the left side and bottom surface of the bracket is 30 degrees;

FIG. 16 is a left or right view of the bracket, wherein the bottom surface of the bracket is attached to the substrate, and an included angle between the left side and bottom surface of the bracket is 45 degrees;

FIG. 17 is a front view of the bracket, wherein the bottom surface of the bracket is attached to the substrate, the electrode and the dissipating heat fin are attached to the left side, right side and bottom surface of the bracket, and an included angle between the left side and bottom surface of the bracket is 45 degrees; and

FIG. 18 is a front view of the bracket, wherein the bottom surface of the bracket is attached to the substrate, and an included angle between the left side and bottom surface of the bracket is 60 degrees.
Reference numerals : 1-top surface; 2- bottom surface; 3-front surface; 4-rear surface; 5-left side; 6-right side; 7-electrode; 8- dissipating heat fin; 9-cup; 10-substrate.

### DETAILED DESCRIPTION OF THE PREFERRED EMBODIMENTS

Objects, advantages and embodiments of the present invention will be explained below in detail with reference to the accompanying drawings. However, it is to be appreciated that the following description of the embodiment(s) is merely exemplary in nature and is no way intended to limit the invention, its application, or uses.

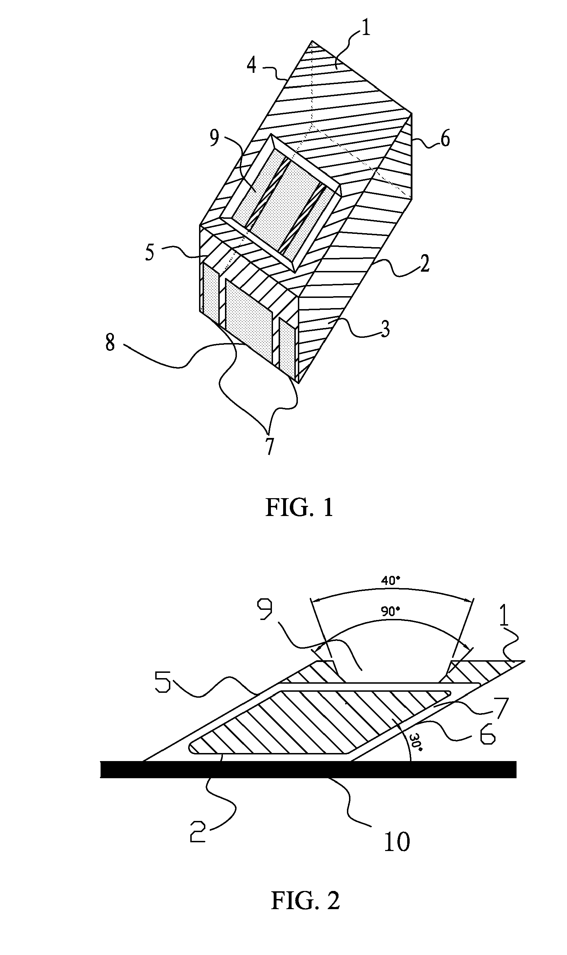

Referring to FIG. 1, a bracket for supporting an LED includes a top surface 1, a bottom surface 2, a front surface 3, a rear surface 4, a right side 5 and a left side 6. An electrode 7 and a dissipating heat fin 8, made of copper or silver or alloy material, are tightly attached to the right side 5, left side 6 and bottom surface 2 of the bracket. The electrode 7 and dissipating heat fin 8 may be connected to the right side 5 or left side 6 of the bracket. A cup 9 is disposed on the top surface 1 of the bracket, and the cup is made of conducting heat insulation material includes ALN, ceramic material, silicon material or plastic material; the cup 9 may be rectangular or oval, and its corner is round. An inner side of the cup 9 defines at least one angle R which the range of the angle R may be from 40 degrees to 90 degrees. The front surface 3 and rear surface 4 is a parallelogram in shape, and the front surface 3 and rear surface 4 is vertical to the bottom surface 2. An angle R formed between the left side 5 and the bottom surface 2 or between the right side 6 and the bottom surface 2 is in a range from 30 degrees to 60 degrees, preferably is 30 degrees, 45 degrees or 60 degrees. A three-dimensional light source which has good luminous performance in all directions can be obtained by adjusting the angle R according to requirement. The bracket has two or three positions where the substrate can be attached thereto, that is, the electrode 7 and dissipating heat fin 8 extend to an external location of the bracket, and disposed on the left side 5, the right side 6 or the bottom 2 of the bracket.

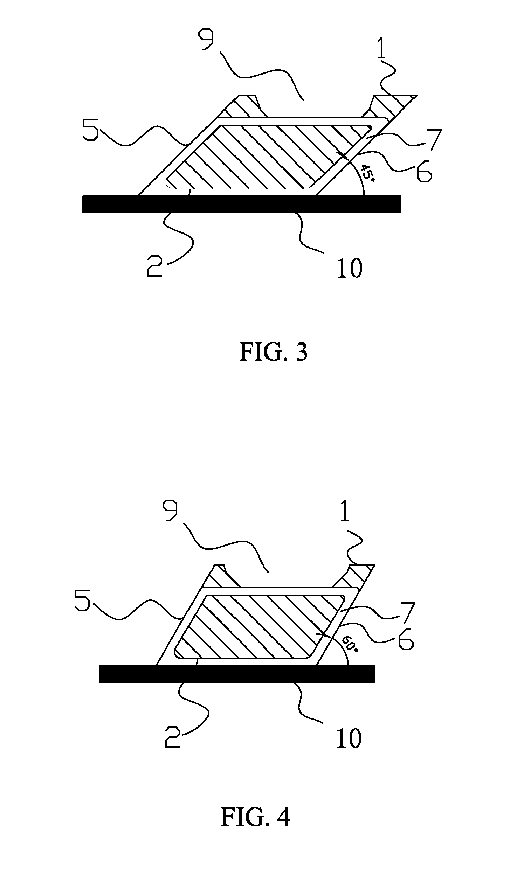

Referring to FIGS. 2-4, 10-12, 13-16, and 17-18, in FIG. 2, the bottom surface 2 of the bracket is attached to the substrate 10. The electrode 7 and the dissipating heat fin 8 attached to the left and right sides 5, 6 are connected to the bottom surface 2 of the bracket. An included angle between the left side 5 of the bracket and the bottom surface 2 is 30 degrees, and an included angle between the right side 6 of the bracket and the bottom surface 2 is also 30 degrees. In FIG. 3, the bottom surface 2 of the bracket is affixed to the substrate 10. The electrode 7 and the dissipating heat fin 8 affixed to the left and right sides 5, 6 are connected to the bottom surface 2 of the bracket. An included angle between the left side 5 of the bracket and the bottom surface 2 is 45 degrees, and an included angle between the right side 6 of the bracket and the bottom surface 2 is also 45 degrees. In FIG. 4, the bottom surface 2 of the bracket is affixed to the substrate 10. The electrode 7 and the dissipating heat fin 8 affixed to the left and right sides 5, 6 are connected to the bottom surface 2 of the bracket. An included angle between the left side 5 of the bracket and the bottom surface 2 is 60 degrees, and an included angle between the right side 6 of the bracket and the bottom surface 2 is also 60 degrees.

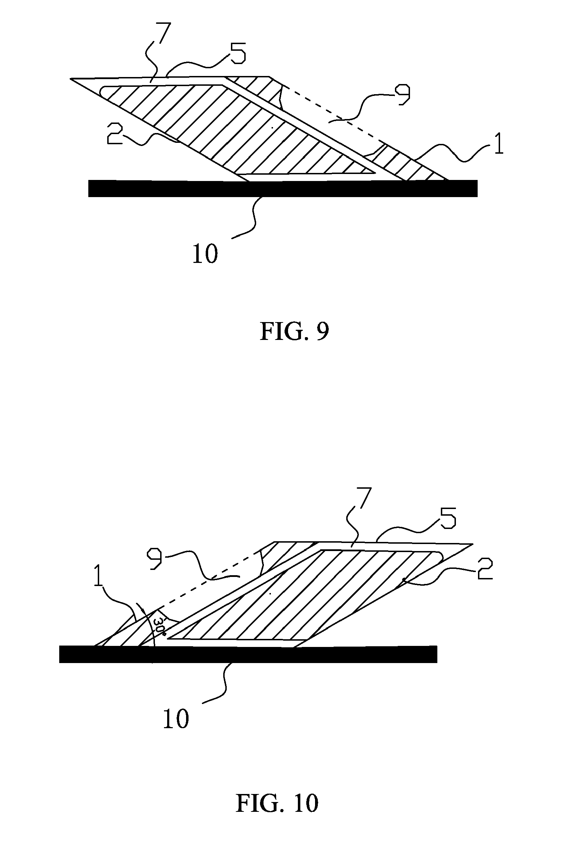

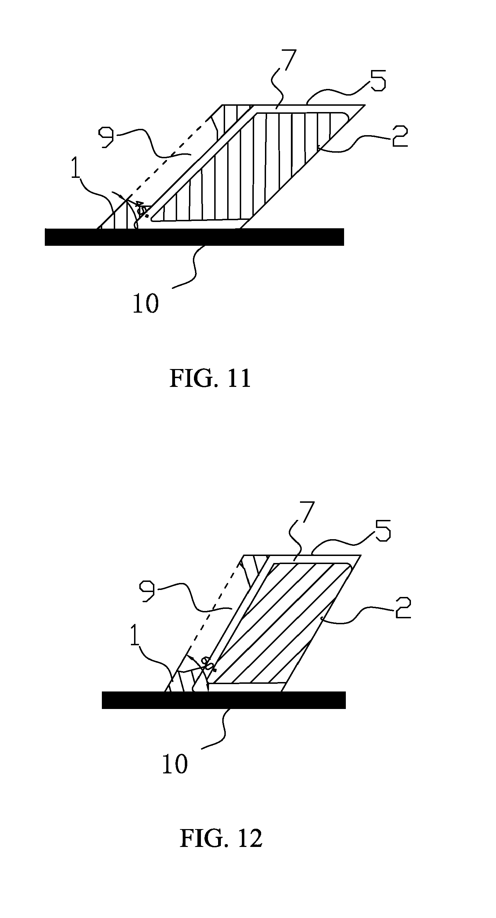

Referring to FIG. 10, the right side 6 of the bracket is attached to the substrate 10. The electrode 7 and the dissipating heat fin 8 are attached to the left and right sides 5, 6. The top surface 1 of the bracket faces to a left side. An included angle between the left side 5 of the bracket and the bottom surface 2 is 30 degrees. In FIG. 11, the right side 6 of the bracket is attached to the substrate 10. The electrode 7 and the dissipating heat fin 8 are attached to the left and right sides 5, 6. The top surface 1 of the bracket faces to a left side. An included angle between the left side 5 of the bracket and the bottom surface 2 is 45 degrees. In FIG. 12, the right side 6 of the bracket is attached to the substrate 10. The electrode 7 and the dissipating heat fin 8 are attached to the left and right sides 5, 6. The top surface 1 of the bracket faces to a left side. An included angle between the left side 5 of the bracket and the bottom surface 2 is 60 degrees.

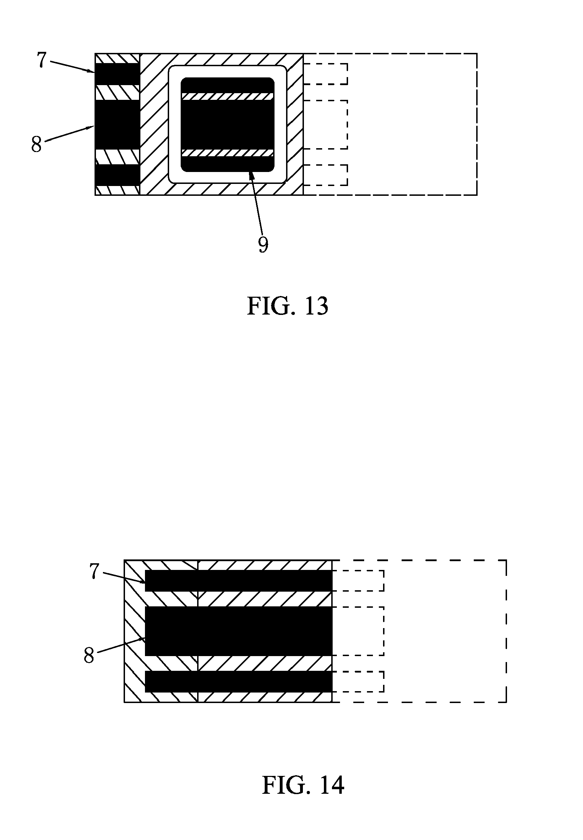

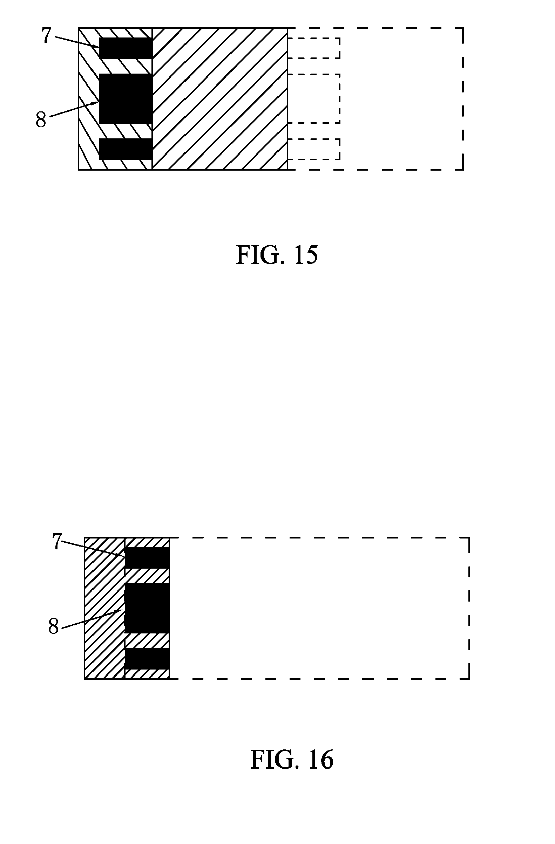

Referring to FIG. 13, the bottom surface 2 of the bracket is attached to the substrate 10. An included angle between the left side 5 of the bracket and the bottom surface 2 is 30 degrees. In FIG. 14, the bottom surface 2 of the bracket is attached to the substrate 10. The electrode 7 and the dissipating heat fin 8 affixed to the left and right sides 5, 6 are connected to the bottom surface 2 of the bracket. An included angle between the left side 5 of the bracket and the bottom surface 2 is 30 degrees. In FIG. 15, the bottom surface 2 of the bracket is attached to the substrate 10. The electrode 7 and the dissipating heat fin 8 are affixed to the left and right sides 5, 6. An included angle between the left side 5 of the bracket and the bottom surface 2 is 30 degrees. In FIG. 16, the bottom surface 2 of the bracket is attached to the substrate 10. An included angle between the left side 5 of the bracket and the bottom surface 2 is 45 degrees.

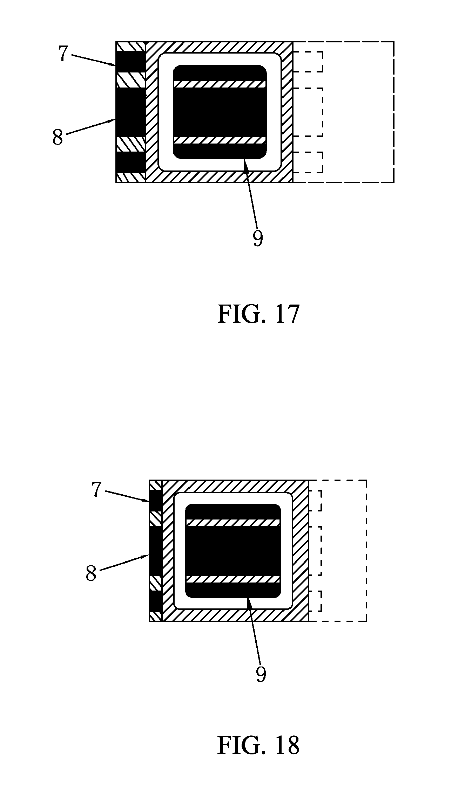

In FIG. 17, the bottom surface 2 of the bracket is attached to the substrate 10. The electrode 7 and the dissipating heat fin 8 affixed to the left and right sides 5, 6 are connected to the bottom surface 2 of the bracket. An included angle between the left side 5 of the bracket and the bottom surface 2 is 45 degrees. In FIG. 18, the bottom surface 2 of the bracket is attached to the substrate 10. An included angle between the left side 5 of the bracket and the bottom surface 2 is 60 degrees. A three-dimensional lighting source with good light-emitting performance in all directions may be obtained by adjusting the included angle between the left or right side and the bottom surface.

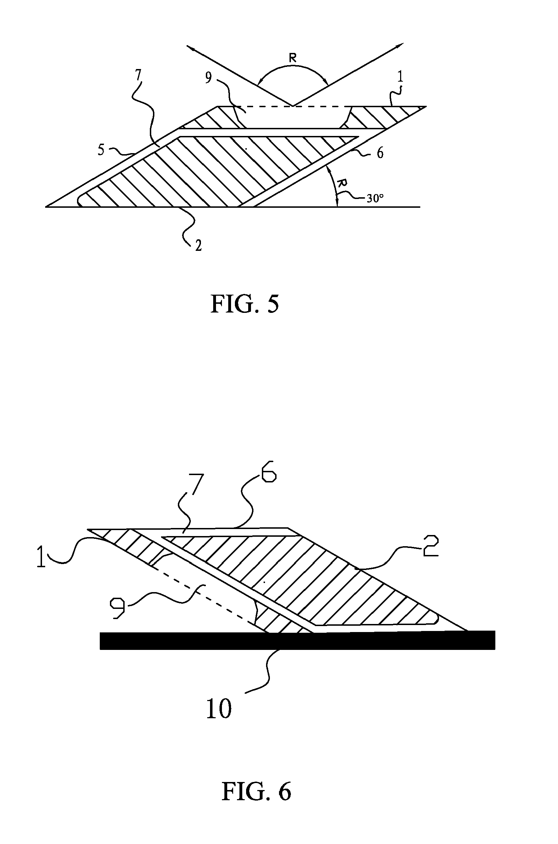

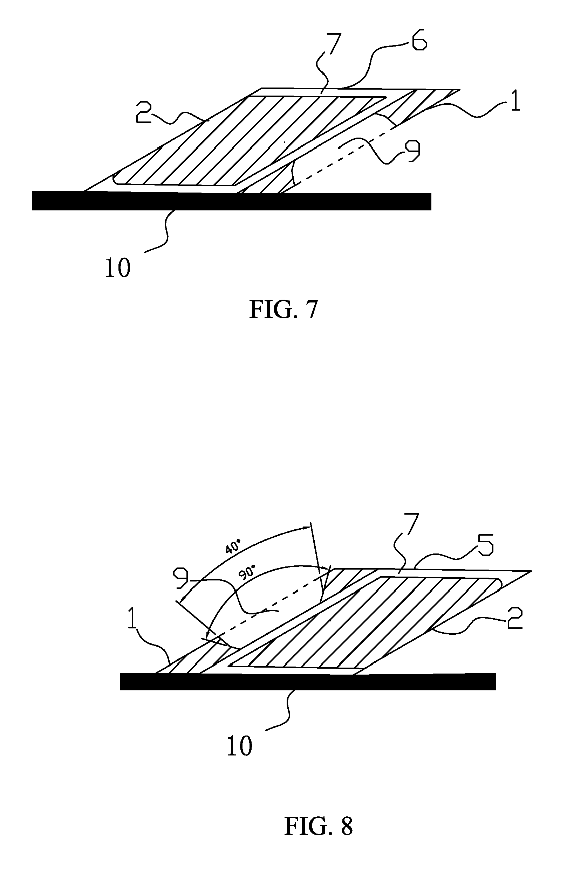

Referring to FIGS. 5-9, in FIG. 5, the electrode 7 and the dissipating heat fin 8 are not connected to the bottom surface 2 of the bracket. In FIG. 6, the left side 5 of the bracket is affixed to the substrate 10. The electrode 7 and the dissipating heat fin 8 are affixed to the left and right sides 5, 6 of the bracket, and the top surface 1 of the bracket faces to a left side. In FIG. 7, the left side 5 of the bracket is affixed to the substrate 10. The electrode 7 and the dissipating heat fin 8 are affixed to the left and right sides 5, 6 of the bracket, and the top surface 1 of the bracket faces to a right side. In FIG. 8, the right side 6 of the bracket is affixed to the substrate 10. The electrode 7 and the dissipating heat fin 8 are affixed to the left and right sides 5, 6 of the bracket, and the top surface 1 of the bracket faces to a left side. In FIG. 9, the right side 6 of the bracket is affixed to the substrate 10. The electrode 7 and the dissipating heat fin 8 are affixed to the left and right sides 5, 6 of the bracket, and the top surface 1 of the bracket faces to a right side. The dissipating heat fin 8 may be mounted on a different surface, so that the bracket can be adapted for different light-emitting angle requirements, also, the bracket are effectively increased dissipating heat area to thereby extend use life of the lamp.

The bracket has the following advantages: Firstly, the bracket which is a parallelepiped in shape in the present invention is different from the conventional bracket which is cube or cuboid. The four side edges of the conventional bracket are vertical to a bottom surface. However, the left and right side of the bracket in the present invention is inclined to the bottom surface. When the bracket is affixed to the substrate, a three-dimensional light source which has good luminous performance in all directions may be obtained by adjusting the angle R according to requirement. Secondly, the conventional bracket only has one cooling surface, and the bracket in the present invention has two or three cooling surfaces, thereby effectively increasing the cooling area and increasing use life of a lamp. Thirdly, a bottom surface of the conventional is only attached to the substrate, while the bracket in the present invention may have two or three surfaces attached to the substrate, thereby conveniently adjusting a lighting angle, so that the bracket can adapt for different lighting angle requirements. Fourthly, the brightness of a single LED configured with the bracket in the present invention is the same as the conventional TOP LED configured with the conventional bracket.

The present invention may be embodied in other forms without departing from the spirit or novel characteristics thereof. The embodiments disclosed in this application are to be considered in all respects as illustrative and not limitative. The scope of the invention is indicated by the appended claims rather than by the foregoing description; and all changes which come within the meaning and range of equivalency of the claims are intended to be embraced therein.

Features, components and specific details of the structures of the above-described embodiments may be exchanged or combined to form further embodiments optimized for the respective application. As far as those modifications are readily apparent for an expert skilled in the art they shall be disclosed implicitly by the above description without specifying explicitly every possible combination, for the sake of conciseness of the present description.

## Claims

1. A bracket for supporting an LED, comprising:
a top surface (1);
a bottom surface (2) opposite to the top surface (1);
a front surface (3);
a rear surface (4) opposite to the front surface (3), wherein the front and rear surfaces (3, 4) are a parallelogram in shape, and vertical to the bottom surface (2);
a left side (5); and
a right side (6) opposite to the left side (5), wherein an electrode (7) and a dissipating heat fin (8) are attached to the left and right sides of the bracket, an included angle between the left side (5) or right side (6) and the bottom surface (2) is substantially in a range from 30 degrees to 60 degrees, and the electrode (7) and dissipating heat fin (8) are attached to the bottom surface (2).

2. The bracket as claimed in claim 1, wherein the included angle between the left side (5) or right side (6) and the bottom surface (2) is substantially 30 degrees, 45 degrees, or 60 degrees.

3. The bracket as claimed in claim 1 or 2, wherein the electrode (7) and dissipating heat fin (8) are firmly attached to the left and right sides.

4. The bracket as claimed in at least one of claims 1 - 3, further comprising a rectangular cup (9) disposed on the bottom surface (2).

5. The bracket as claimed in claim 4, wherein at least one angle is formed on a side wall of the rectangular cup (9), and the angle is substantially in a range from 40 degrees to 90 degrees.

6. The bracket as claimed in at least one of claims 1 - 5, wherein the electrode (7) and the dissipating heat fin (8) are made of copper, silver, or alloy material.

7. The bracket as claimed in at least one of claims 4 - 6, wherein the rectangular cup (9) is made of conducting heat insulation material.

8. The bracket as claimed in claim 7, wherein the conducting heat insulation material comprises ALN, ceramic, silicon substrate or plastic material.

9. The bracket as claimed in at least one of claims 4 - 8, wherein the rectangular cup (9) is square or oval-shaped, and a corner of the rectangular cup (9) is a rounded corner.

10. The bracket as claimed in at least one of claims 1 - 9, wherein the electrode (7) and dissipating heat fin (8) extend to an external surface of the bracket, and the left side (5), the right side (6) or the bottom surface (2) is attached to a substrate.
